# EUROPEAN PATENT SPECIFICATION

(11) **EP 2 141 969 B1**
(45) Date of publication and mention of the grant of the patent: **24.04.2013**
(21) Application number: 09164161.3
(22) Date of filing: 30.06.2009
(51) Int. Cl.: H05K 1/02

(54) **A method for making a three-dimensional multi-layered interconnect device**
Verfahren zur Herstellung einer dreidimensionalen mehrschichtigen Verbindungsvorrichtung
Procédé de fabrication de dispositif d'interconnexion multicouche tridimensionnelle

(30) Priority: 02.07.2008 NL 1035663
(43) Date of publication of application: 06.01.2010
(73) Proprietor: THALES NEDERLAND B.V., 7550 GD Hengelo (NL)
(72) Inventor: Legtenberg, Rob, 7557 HC HENGELO (NL)
(74) Representative: Lucas, Laurent Jacques

(56) References cited:
- EP-A- 1 209 959
- US-A- 4 710 419
- US-A- 5 449 480

## Description

The present invention relates to a method for making an interconnect device having a 3D-shaped structure and comprising a plurality of interconnection layers. For example, the invention is particularly applicable to antenna modules for radar and telecom.

Nowadays radar systems may use a scanning phased array antenna to cover their required angular range. Such an antenna comprises a large number of identical radiator elements assembled onto a panel so as to form an array of radiator elements. The control of the phase shifting between adjacent radiator elements enables to control the scanning angles of the beam emitted by the array antenna. The techniques that are the most commonly used to build an array antenna are based on interconnect substrate technologies, e.g. the Printed Circuit Board technology (PCB). These thick-film or thin-film multilayer technologies consist in many sequential steps of laminating layers, of drilling holes through the layers and of metallizing the holes. These sequential build-up technologies typically result in planar interconnect devices comprising multiple interconnection layers.

However, the next generation of compact scanning phased array antennas require the Radio-Frequency (RF) radar functionality to be implemented directly at the antenna face. This cannot be achieved by the above mentioned techniques, as they typically result in planar interconnect devices that do not afford extra room to embed the required RF components. This is one of the technical problems that the present invention aims at solving.

In an attempt to achieve this goal, 3D-shaped radiator elements, so-called radiator packages, may afford sufficient extra interior room. It is worth noting that a 3D radiator package also yields design possibilities in terms of bandwidth and scan-angle that a planar device radiator cannot. The general aspect of a radiator package is that of a hollowed box topped by an integrated antenna. A large number of radiator packages are assembled onto a PCB so as to form an array of radiator packages. The international patent application No. WO/2003/021678 discloses a method to form a package for electronics components, based on the well-known 3-Dimensional Molded Interconnect Device technology (3D-MID). Basically, the 3D-MID technology consists in a step of molding a hollowed 3D plastic body and a step of metallizing the outer surface of the moulded body. The 3D-MID technology typically results in an interconnection laying out on the three-dimensional outer surface of a moulded body. Hereby, a two layer interconnection pattern can be achieved, i.e. a pattern on the top-side of the 3D interconnect device and a pattern on the bottom-side of the 3D interconnect device. For example, one of these two patterns may form a patch antenna. Unfortunately, the 3D-MID technology does not enable to achieve a 3D interconnect device comprising more than two interconnection layers.

Indeed, a few specific applications may require a 3D interconnect device comprising many more than two interconnection layers. For example, the Active Electronically Scanned Array (AESA) antennas require highly integrated antenna radiator package modules, so-called cavity-backed slot-coupled patch antenna module, which include as many as four metallization layers. Another design requiring more than two metallization layers is for example a stacked patch design. These modules must also accomodate several component packaging functions, like electrical and RF interconnections or EM-shielding. 3D-MID package modules would be able to embed these component packaging functions. However, cavity-backed slot-coupled patch antenna module must also yield high performance, especially in terms of bandwidth and scan-angle. Unfortunately, 3D-MID package modules yield average performance only, i.e. a narrow band and a small scan-angle. The reason is that their performance is limited by design schemes, which are typically based on a single or a double metallization layers, like in a direct coupled feed structure.

It clearly appears that the existing techniques fail at providing an interconnect device that combines the extra interior room with the multilayer interconnection feature. Existing substrate interconnection technologies, such as PCB technology, achieve multilayer interconnection feature but fail at affording the extra interior room and additional mechanical features. Whereas existing three-dimensional interconnect technologies, such as 3D-MID technology, affords the extra interior room but fail at providing more than two interconnection layers. This is another technical problem that the present invention aims at solving.

The patent US 4,710,419 discloses an in-mold process for fabrication of molded plastic printed circuit boards. Patent US 5,449,480 discloses a method of producing boards for printed wiring.

The present invention aims to provide a method which may be used to overcome at least some of the technical problems described above. At its most general, the present invention described hereafter may provide a method for making a three-dimensional interconnect device, the device comprising a plurality of interconnection layers. The method comprises a step of laminating a printed circuit board comprising a plurality of interconnection layers. The method comprises a step of inserting the printed circuit board in a three-dimensional mold. The method comprises a step of injecting a molding material into the mold, so as to form a three-dimensional non-planar structure encompassing the printed circuit board. The method comprises a step of metallizing a portion of the outer surface of the three-dimensional structure, so that it is connected with at least one interconnection layer of the printed circuit board.

Preferably, the lamination material used during the step of laminating and the molding material used during the step of molding may be adapted to establish a weld junction between the printed circuit board and the three-dimensional structure. Preferably, the method may comprise a step of preparing the printed circuit board before it is inserted in the mold, the printed circuit board being treated with an alkaline conditioner and with a sulfuric-peroxide based chemistry to create an organo-metallic conversion coating. For example, the alkaline conditioner may be an NaOH solution and the sulfuric-peroxide based chemistry may be AlfaPREP PC 7030 (TradeMark).

For example, the step of metallizing the portion of the outer surface may include forming a patch antenna, so that the device is adapted for use as an antenna radiator module.

For example, the lamination material may be Roger 4003.

For example, the molding material may be a thermoset molding material like an epoxy resin or a thermoplastic molding material like polyetherimid or liquid crystal polymer.

In any of its aspects, the invention disclosed herein enables to combine in a single final product the advantages of the technologies known from the prior art. Similarly to the PCB technology, the present invention conveniently provides flexibility in dielectric thickness between antenna layers, the possibility of assembling SMT components (Surface Mount Technology) or IC's (Integrated Circuits), as well as the possibility of overmolding electronics. It also provides a high level of integration for electrical interconnections or for mechanical features like aligning and assembling. Similarly to the 3D-MID technology, the present invention conveniently provides packaging and protection of embedded electronics. Connector functionality can suitably be molded to the multilayer printed circuit board.

The invention disclosed herein enables to implement a 3D multilayered interconnect device that comprises electrical functions and interconnection densities that cannot be achieved by existing 3D-MID-like technologies, these latter being limited to interconnections on the outer surface.

A non-limiting exemplary embodiment of the invention is described below with reference to the accompanying drawings in which :

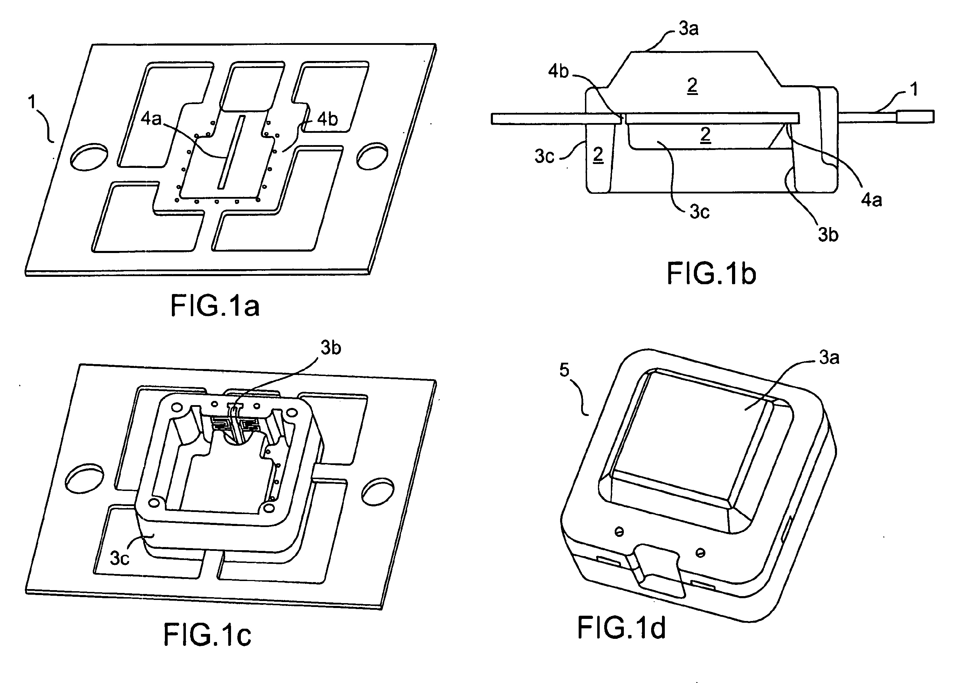

- figure 1 a schematically illustrates by a perspective view of an insert multilayer PCB suitable for the exemplary embodiment;
- figure 1b schematically illustrates by a cross section the exemplary embodiment of the invention;
- figure 1c schematically illustrates by an inside view the exemplary embodiment of the invention;
- figure 1d schematically illustrates by a perspective view the exemplary embodiment of the invention.
In the figures, like reference signs are assigned to like items.

The figures 1a, 1b, 1c and 1d schematically illustrate an exemplary embodiment of the invention, which is adapted to be used as a cavity-backed slot-coupled patch antenna module for an AESA antenna. Indeed, the invention enables to create a 3D-shaped integrated module with layer buildups that yields the bandwidth and scan-angle required by an AESA antenna.

A multilayer PCB insert 1 is laminated. The lamination material used is selected in regard of its compatibility with a molding process. For example, Rogers 4003 (TradeMark) is a lamination material that both resists high temperature and pressure. Advantageously, Rogers 4003 is compatible with most thermoplastic and thermoset molding materials and processes, which means that it is adapted to establish a weld junction with most of these molding materials when heated. For example, Rogers 4003 may be used in association with a thermoset molding material like an epoxy resin. It may also be used in association with a thermoplastic molding material like polyetherimide (PEI) or liquid crystal polymer (LCP). In the present example, PEI resin may be used. The insert 1 is pre-treated with an alkaline conditioner, like an NaOH solution for example, and with sulfuric-peroxide based chemistry, like AlfaPREP PC-7030 (TradeMark) for example, to create an organo-metallic conversion coating. The multilayer PCB insert 1 is then dried and inserted in a three-dimensional mold, like any conventional metal insert. In the present example, PEI and LCP resin is heated, then injected in the mold and pressured, resulting in a 3D moulded structure 2 encompassing the multilayer PCB insert 1 by virtue of a weld junction. Afterwards, metallization processes are applied to the outer surface of the 3D moulded structure 2. A metallization pattern 3a forms a patch antenna. A metallization pattern 3b is connected to an inner track pattern 4a of the multilayer PCB insert 1. A metallization pattern 3c forms grounding layers and is connected to a grounding layer 4b of the multiplayer PCB insert 1, the grounding layer 4b including metallized vias running through the insert 1.

The outer metallization patterns 3a, 3b and 3c may be applied by a laser subtractive structuring technique. First, the outer surface of the 3D moulded structure 2 may be chemically plated with copper in the range of 1 to 10 micrometers for example. Where needed, the thickness of this layer may be increased up to several tens of micrometers by a galvanic copper plating. After copper plating, a chemical tin layer of 0.1 to 1 micrometer may be deposited and then patterned by a 3D laser structuring technique. Afterwards, the tin layer may be used as a three-dimensional mask during copper etching, after which the tin layer may be stripped. Another option might be to metallize the outer surface of the 3D moulded structure 2 with a suitable surface finish, for example nickel and gold. However, in any case, the metallization process shall ensure that the outer metallization patterns 3b and 3c are connected to the inner metallization patterns 4a and 4b. The above mentioned process of preparing the multilayer PCB insert 1 before it is inserted in the mold is intended to obtain a good adhesion between the insert 1 and the molding material in order to obtain a reliable interconnection. After removal of external features of the insert 1, as better illustrated by Figure 1c and Figure 1d, a final 3D-MID radiator 5 is obtained.

The 3D-MID radiator 5 may be assembled onto a carrier so as to form an antenna module.

It is to be understood that variations to the example described above, such as would be apparent to the skilled addressee, may be made without departing from the scope of the present invention, as defined by the claims.

The invention disclosed herein discloses a convenient, simple, flexible and compact solution that may comply with requirements of other high-end electronic applications than highly integrated radar applications. For example, the invention may comply with the requirements of the telecom base stations. Considering its low cost in regard of its performance, the present invention is a particularly cost-efficient solution.

## Claims

1. A method for making a three-dimensional interconnect device, the device comprising a plurality of interconnection layers, comprising the following steps :
- a step of laminating a printed circuit board (1) comprising a plurality of interconnection layers;
- a step of inserting the printed circuit board in a three-dimensional mold;
- a step of injecting a molding material into the mold, so as to form a three-dimensional non-planar structure (2) encompassing the printed circuit board; and
- a subsequent step of metallizing a portion (3a, 3b, 3c) of the outer surface of the three-dimensional structure so that it is connected with at least one interconnection layer (4a, 4b) of the printed circuit board.

2. A method according to Claim 1, **characterized in that** the lamination material used during the step of laminating and the molding material used during the step of molding are adapted to establish a weld junction between the printed circuit board and the three-dimensional structure.

3. A method according to Claim 1, **characterized in that** it comprises a step of preparing the printed circuit board before it is inserted in the mold, the printed circuit board being treated with an alkaline conditioner and with a sulfuric-peroxide based chemistry to create an organo-metallic conversion coating.

4. A method according to Claim 3, **characterized in that** the alkaline conditioner is an NaOH solution.

5. A method according to Claim 1, **characterized in that** the step of metallizing the portion of the outer surface includes forming a 3D patch antenna, so that the device is adapted for use as an antenna radiator module.

6. A method according to Claim 1, **characterized in that** the molding material is a thermoset molding material.

7. A method according to Claim 6, **characterized in that** the thermoset molding material is an epoxy resin.

8. A method according to Claim 1, **characterized in that** the molding material is a thermoplastic molding material.

9. A method according to Claim 8, **characterized in that** the thermoplastic molding material is polyetherimide.

10. A method according to Claim 8, **characterized in that** the thermoplastic molding material is a liquid crystal polymer.

## Patentansprüche

1. Verfahren zur Herstellung einer dreidimensionalen Verbindungsvorrichtung, wobei die Vorrichtung mehrere Verbindungsschichten umfasst, das die folgenden Schritte beinhaltet:
- einen Schritt des Laminierens einer nichtplanare Leiterplatte (1), die mehrere Verbindungsschichten umfasst;
- einen Schritt des Einfügens der Leiterplatte in eine dreidimensionale Form;
- einen Schritt des Injizierens eines Formmaterials in die Form, um eine dreidimensionale nichtplanare Struktur (2) zu formen, die die Leiterplatte umgibt; und
- einen Folgeschritt des Metallisierens eines Abschnitts (3a, 3b, 3c) der Außenfläche der dreidimensionalen Struktur, so dass sie mit wenigstens einer Verbindungsschicht (4a, 4b) der Leiterplatte verbunden ist.

2. Verfahren nach Anspruch 1, **dadurch gekennzeichnet, dass** das beim Laminierungsschritt verwendete Laminierungsmaterial und das beim Formschritt verwendete Formmaterial so ausgelegt sind, dass sie eine Schweißbrücke zwischen der Leiterplatte und der dreidimensionalen Struktur herstellen.

3. Verfahren nach Anspruch 1, **dadurch gekennzeichnet, dass** es einen Schritt des Vorbereitens der Leiterplatte vor deren Einfügen in die Form beinhaltet, wobei die Leiterplatte mit einem alkalischen Konditionierer und mit einer Chemikalie auf der Basis von Schwefelperoxid behandelt wird, um eine metallorganische Konversionsschicht zu erzeugen.

4. Verfahren nach Anspruch 3, **dadurch gekennzeichnet, dass** der alkalische Konditionierer eine NaOH-Lösung ist.

5. Verfahren nach Anspruch 1, **dadurch gekennzeichnet, dass** der Schritt des Metallisierens des Abschnitts der Außenfläche das Bilden einer 3D-Patch-Antenne beinhaltet, so dass die Vorrichtung als Antennenstrahlermodul eingesetzt werden kann.

6. Verfahren nach Anspruch 1, **dadurch gekennzeichnet, dass** das Formmaterial ein duroplastisches Formmaterial ist.

7. Verfahren nach Anspruch 6, **dadurch gekennzeichnet, dass** das duroplastische Formmaterial ein Epoxidharz ist.

8. Verfahren nach Anspruch 1, **dadurch gekennzeichnet, dass** das Formmaterial ein thermoplastisches Formmaterial ist.

9. Verfahren nach Anspruch 8, **dadurch gekennzeichnet, dass** das thermoplastische Formmaterial Polyetherimid ist.

10. Verfahren nach Anspruch 8, **dadurch gekennzeichnet, dass** das thermoplastische Formmaterial ein Flüssigkristallpolymer ist.

## Revendications

1. Procédé de fabrication d'un dispositif d'interconnexion en trois dimensions, ledit dispositif comprenant une pluralité de couches d'interconnexion, comprenant les étapes suivantes :
- une étape de stratification d'une carte de circuit imprimé non plane comprenant une pluralité de couches d'interconnexion ;
- une étape d'insertion de ladite carte de circuit imprimé dans un moule en trois dimensions ;
- une étape d'injection d'un matériau de moulage dans ledit moule, de façon à former une structure non plane en trois dimensions (2) qui comprend ladite carte de circuit imprimé ; et
- une étape ultérieure de métallisation d'une partie (3a, 3b, 3c) de la surface extérieure de ladite structure en trois dimensions afin qu'elle soit reliée à au moins une couche d'interconnexion (4a, 4b) de ladite carte de circuit imprimé.

2. Procédé selon la revendication 1, **caractérisé en ce que** ledit matériau de stratification utilisé pendant ladite étape de stratification et ledit matériau de moulage utilisé pendant ladite étape de moulage sont adaptés pour établir une soudure entre ladite carte de circuit imprimé et ladite structure en trois dimensions.

3. Procédé selon la revendication 1, **caractérisé en ce qu'**il comprend une étape de préparation de ladite carte de circuit imprimé avant qu'elle ne soit insérée dans ledit moule, ladite carte de circuit imprimé étant traitée avec un conditionneur alcalin et avec un produit chimique à base de peroxyde de soufre afin de créer un revêtement de conversion organométallique.

4. Procédé selon la revendication 3, **caractérisé en ce que** ledit conditionneur alcalin est une solution de NaOH.

5. Procédé selon la revendication 1, **caractérisé en ce que** ladite étape de métallisation de ladite partie de la surface extérieure comprend la formation d'une antenne à plaque en 3D, afin que ledit dispositif soit adapté pour être utilisé comme un module de pylône d'antenne.

6. Procédé selon la revendication 1, **caractérisé en ce que** ledit matériau de moulage est un matériau de moulage thermodurcissant.

7. Procédé selon la revendication 6, **caractérisé en ce que** ledit matériau de moulage thermodurcissant est une résine d'époxy.

8. Procédé selon la revendication 1, **caractérisé en ce que** ledit matériau de moulage est un matériau de moulage thermoplastique.

9. Procédé selon la revendication 8, **caractérisé en ce que** ledit matériau de moulage thermoplastique est du polyétherimide.

10. Procédé selon la revendication 8, **caractérisé en ce que** ledit matériau de moulage thermoplastique est un polymère de cristal liquide.
